# EUROPÄISCHE PATENTANMELDUNG

(11) **EP 1 191 831 A1**
(43) Veröffentlichungstag der Anmeldung: **27.03.2002**
(21) Anmeldenummer: 00810824.3
(22) Anmeldetag: 13.09.2000
(51) Int. Cl.: H05K 13/04, H01L 21/00

(54) **Vorrichtung für die Montage von Halbleiterchips**

(71) Anmelder: Esec Trading S.A., 6330 Cham (CH)
(72) Erfinder: Mannhart, Eugen, Dr., 6330 Cham (CH); Günther, Thomas, 8800 Thalwil (CH); Leu, Felix, 6300 Zug (CH); Dschen, Tsing, Dr., 8953 Dietikon (CH)
(74) Vertreter: Falk, Urs, Dr.

(57) **Zusammenfassung**

Eine Vorrichtung für die Montage von Halbleiterchips umfasst einen Bondkopf (5) mit einem Greifer (6) mit einer mit Vakuum beaufschlagbaren Längsbohrung (9) zum Erfassen und Transportieren eines Halbleiterchips (7). Zum Nachweis, ob der Greifer (6) den Halbleiterchip (7) ergriffen hat, ist in der Längsbohrung (9) des Greifers (6) ein mit einer spiegelnden Fläche ausgebildeter Körper (15) angeordnet, der beim Überfahren einer Lichtquelle (10) bei Fehlen des Halbleiterchips (7) von unten in die Längsbohrung (9) des Greifers (6) einfallendes Licht in eine horizontale Ebene (17) umlenkt. Der Greifer (6) weist für das umgelenkte Licht der Lichtquelle (10) durchlässige Stellen auf. Am Bondkopf (5) ist mindestens ein optisches Element (19; 19.1, 19.2) angeordnet, das wenigstens einen Teil des umgelenkten, seitlich aus dem Greifer (6) austretenden Lichtes auf einem Photosensor (18) konzentriert.

## Beschreibung

Die Erfindung betrifft eine Vorrichtung für die Montage von Halbleiterchips der im Oberbegriff des Anspruchs 1 genannten Art.

Für die Montage von Halbleiterchips werden als Montageautomat sogenannte Die Bonder eingesetzt, bei denen ein Bondkopf den zu montierenden Halbleiterchip an einem ersten Ort aufnimmt und an einem zweiten Ort auf einem Substrat plaziert. Der Bondkopf weist einen mit einer Vakuumdüse versehenen Greifer auf, mit dem der Halbleiterchip während des Transports gehalten wird. Für die Überprüfung, ob der Halbleiterchip erfolgreich ergriffen wurde, sind verschiedene Messsysteme entwickelt worden. Bei einem ersten Messsystem befindet sich im Bondkopf am oberen Ende der Vakuumdüse ein Photosensor. Auf dem Weg vom ersten Ort zum Substrat überfährt der Greifer eine Lichtquelle, die im Photosensor dann einen Lichtimpuls erzeugt, wenn sich kein Halbleiterchip am Greifer befindet. Eine optimale Ausbildung des Messsystems ist aus Platzgründen nicht möglich, da der Bondkopf verschiedene Funktionen bei möglichst geringer Masse erfüllen muss.

Bei einem weiteren bekannten Messsystem wird der Halbleiterchip auf dem Transportweg durch eine Lichtschranke geführt. Nachteilig bei diesem System ist, dass die Lichtschranke exakt auf die Transporthöhe justiert werden muss.

Die Messung der Stärke des Vakuums in der Vakuumdüse, das grösser sein sollte, wenn der Halbleiterchip ergriffen ist und die Düse abdichtet, hat sich nur teilweise als tauglich erwiesen, da die Abdichtung durch den Halbleiterchip bei Die-Collet Greifern oftmals sehr schlecht ist.

Der Erfindung liegt die Aufgabe zugrunde, ein Messsystem zu entwickeln, das zuverlässig nachweist, ob sich am Greifer ein Halbleiterchip befindet, und das nicht justiert werden muss.

Die genannte Aufgabe wird erfindungsgemäss gelöst durch die Merkmale des Anspruchs 1.

Die Lösung der Aufgabe gelingt mit einem Messsystem, bei dem das von einer Lichtquelle ausgestrahlte Licht, das bei Abwesenheit des Halbleiterchips in die Längsbohrung des Greifers gelangt, mittels eines optischen Umlenkelementes senkrecht radial zur Längsbohrung ausgekoppelt und zur Detektion einem Photosensor zugeführt wird. Das Messsystem ist zudem bevorzugt mit einem Reflektor versehen, um einen möglichst grossen Anteil des seitlich austretenden Lichtes auf den Photosensor umzulenken.

Nachfolgend werden Ausführungsbeispiele der Erfindung anhand der Zeichnung näher erläutert. Die Figuren sind nicht massstabsgetreu.

Es zeigen:
- Fig. 1: eine Vorrichtung für die Montage von Halbleiterchips mit einem Bondkopf mit einem Greifer,
- Fig. 2: im Querschnitt den Bondkopf mit einem erfindungsgemässen Messsystem,
- Fig. 3: ein erstes Ausführungsbeispiel des Messsystems in der Aufsicht,
- Fig. 4: Details des Greifers,
- Fig. 5: ein zweites Ausführungsbeispiel des Messsystems.

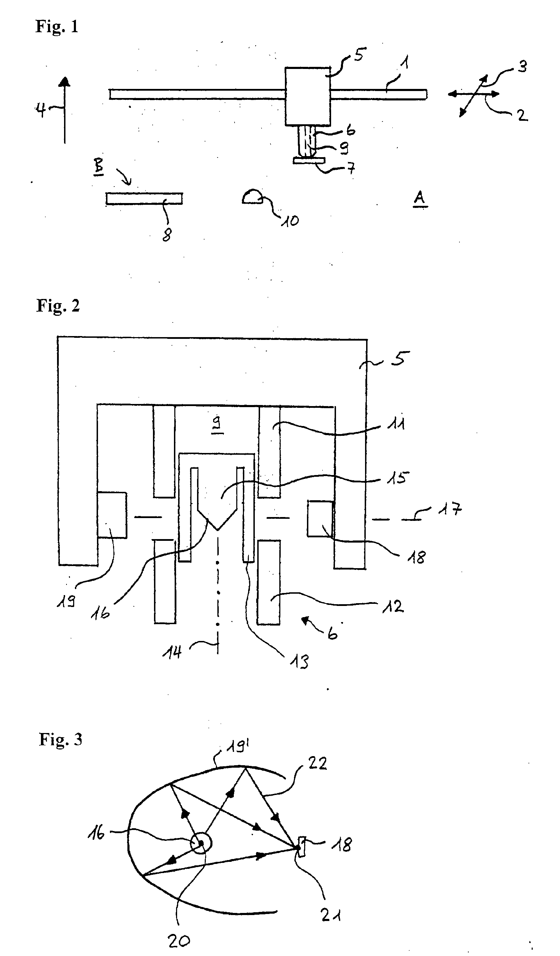

Die Fig. 1 zeigt die für das Verständnis der Erfindung nötigen Teile einer Vorrichtung für die Montage von Halbleiterchips, wie sie beispielsweise aus der europäischen Patentanmeldung EP 923 111 bekannt ist. Die Vorrichtung umfasst ein sogenanntes, in zwei kartesischen Koordinatenrichtungen 2, 3 bewegbares Pick and Place System 1 mit einem in vertikaler Richtung 4 heb- und senkbaren Bondkopf 5 mit einem Greifer 6 zum Transportieren eines Halbleiterchips 7 von einem ersten Ort A zu einem zweiten Ort B, wo der Halbleiterchip 7 auf einem Substrat 8 plaziert wird.

Der Greifer 6 weist eine Längsbohrung 9 auf, die mit Vakuum beaufschlagbar ist, um den Halbleiterchip 7 zu ergreifen. Auf dem Weg vom Ort A zum Ort B überfährt der Bondkopf 5 eine ortsfest angeordnete Lichtquelle 10. Wenn der Halbleiterchip 7 am Greifer 6 haftet, gelangt beim Überfahren der Lichtquelle 10 kein Licht der Lichtquelle 10 in die Längsbohrung 9. Ist kein Halbleiterchip 7 am Greifer 6 vorhanden, dann gelangt Licht der Lichtquelle 10 in die Längsbohrung 9.

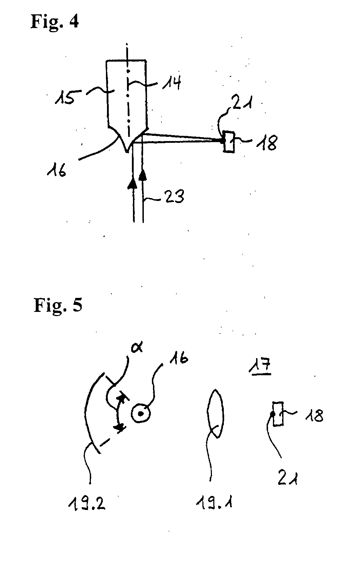

Die Fig. 2 zeigt im Querschnitt den Bondkopf 5 mit dem Greifer 6 und einem Messsystem zur Detektion des bei Abwesenheit des Halbleiterchips 7 in die Längsbohrung 9 gelangenden Lichtes der Lichtquelle 10. Der Greifer 6 ist gegenüber dem Bondkopf 5 in der vertikalen Richtung 4 verschiebbar und um seine Längsachse drehbar. Der Greifer 6 besteht aus einem oberen Teil 11 und einem unteren Teil 12, die beide lichtundurchlässig sind. Das obere Teil 11 und das untere Teil 12 sind durch ein für das Licht der Lichtquelle 10 durchlässiges Kupplungsstück 13 verbunden. Das Kupplungsstück 13 ist in die Längsbohrung 9 im oberen Teil 11 und in die Längsbohrung 9 im unteren Teil 12 eingesteckt. Das Kupplungsstück 13 weist einen auf der Symmetrieachse 14 der Längsbohrung 9 zentrierten Körper 15 mit einer verspiegelten Spitze 16 auf. Die Spitze 16 ist rotationssymmetrisch bezüglich der Längsachse 14 der Längsbohrung 9. Die die Spitze 16 bildende Fläche ist beispielsweise kegelförmig und weist gegenüber der vertikalen Richtung 4 einen Winkel von 45° auf, so dass von unten in die Längsbohrung 9 einfallendes Licht der Lichtquelle 10 an der Spitze 16 in die horizontale Ebene 17 umgelenkt wird und seitlich aus dem Greifer 6 austritt. Am Bondkopf 5 sind ein Photosensor 18 zur Messung des seitlich austretenden Lichtes und mindestens ein optisches Element 19 zur Umlenkung und/oder Konzentration des in die horizontale Ebene 17 austretenden Lichtes auf den Photosensor 18 angeordnet. Aus Gründen der zeichnerischen Klarheit ist das optische Element 19 nur schematisch angedeutet; Einzelheiten über seine Lage und Ausdehnung sind den nachfolgenden Figuren 3 und 5 zu entnehmen. Der Photosensor 18 ist beispielsweise eine Photodiode oder ein Phototransistor.

Beim ersten Ausführungsbeispiel ist das optische Element 19 ein Reflektor mit einer elliptischen Form, wobei sich die verspiegelte Spitze 16 im einen Brennpunkt 20 (Fig. 3) der Ellipse und der Photosensor 18 im anderen Brennpunkt 21 (Fig. 3) der Ellipse befindet. Somit wird das in die horizontale Ebene 17 austretende Licht unabhängig von der Richtung, die es in der horizontalen Ebene 17 einnimmt, auf den Photosensor 18 umgelenkt.

Die Fig. 3 zeigt den elliptischen Reflektor 19', die verspiegelte Spitze 16 und den Photosensor 18 in einem Schnitt durch die horizontale Ebene 17. Eingezeichnet sind auch die beiden Brennpunkte 20 und 21 der Ellipse, sowie verschiedene Strahlenwege 22 des an der Spitze 16 umgelenkten Lichtes. Der elliptische Reflektor 19' ist nicht vollständig geschlossen, da das an ihm reflektierte Licht von vorne auf den Photosensor 18 auffallen muss. Mit dem elliptischen Reflektor 19' können etwa 80% des seitlich austretenden Lichtes auf dem Photosensor 18 konzentriert werden.

Die die Spitze 16 des Körpers 15 bildende Fläche kann auch, wie in der Fig. 4 gezeigt ist, gekrümmt ausgebildet sein, um parallel einfallendes Licht auch in vertikaler Richtung auf den Photosensor 18 zu fokussieren. Die Krümmung ist dem Abstand zwischen der Symmetrieachse 14 und dem Brennpunkt 21, in dem sich der Photosensor 18 befindet, angepasst. Dargestellt sind an verschiedenen Stellen auf die spiegelnde Fläche des Körpers 15 auftreffende und auf den Photosensor 18 umgelenkte Lichtstrahlen 23.

Die Fig. 5 zeigt ein zweites Ausführungsbeispiel, bei dem zwei optische Elemente 19.1 und 19.2 vorhanden sind, um das in die horizontale Ebene 17 umgelenkte Licht auf den Photosensor 18 zu leiten. Das erste optische Element 19.1 ist eine Linse, die einen Teil des an der Spitze 16 umgelenkten Lichtes auf den Photosensor 18 abbildet. Die numerische Apertur der Linse ist möglichst gross. Bei einer numerischen Apertur von 0.5 beträgt der Öffnungswinkel 60°, so dass etwa 17% des in die horizontale Ebene 17 austretenden Lichtes zum Photosensor 18 geleitet werden. Die Symmetrieachse 14 durchstösst den Brennpunkt 20 der Linse. Der Photosensor 18 befindet sich im Brennpunkt 21 der Linse. Das zweite optische Element 19.2 ist ein Reflektor mit annähernd zylindrischer Form und mit einem Umfangswinkel von ebenfalls etwa 60°, der das auf ihn fallende Licht zurückreflektiert, so dass es via Linse ebenfalls zum Photosensor 18 gelangt. Wegen der Abschattung durch die Spitze 16 des Körpers 15 müssen gewisse Verluste in Kauf genommen werden, die etwa 10 - 40% ausmachen können.

Bei beiden Ausführungsbeispielen bestehen die Reflektoren beispielsweise aus hochglanzpoliertem Aluminium. Als Linse kann z.B. eine biasphärische Kunststofflinse mit einer Antireflex Beschichtung verwendet werden.

Um Fehler durch Fremdlicht zu vermeiden, sind das bzw. die optischen Elemente 19 und der Photosensor 18 bevorzugt in einem lichtundurchlässigen Gehäuse untergebracht. Zudem wird bevorzugt die bekannte Lock-In Technik verwendet, bei der das Licht der Lichtquelle 10 moduliert wird.

Dank der Rotationssymmetrie der Spitze 16 ist das Messresultat unabhängig von der momentanen Drehlage des Greifers 6.

## Patentansprüche

1. Vorrichtung für die Montage von Halbleiterchips, mit einem Bondkopf (5) mit einem Greifer (6) mit einer mit Vakuum beaufschlagbaren Längsbohrung (9) zum Erfassen und Transportieren eines Halbleiterchips (7), und mit einer Lichtquelle (10) und einem Photosensor (18) zum Nachweis, ob der Greifer (6) den Halbleiterchip (7) ergriffen hat, wobei bei Abwesenheit des Halbleiterchips (7) Licht der Lichtquelle (10) in die Längsbohrung (9) des Greifers (6) und zum Photosensor (18) gelangt, **dadurch gekennzeichnet, dass** in der Längsbohrung (9) des Greifers (6) ein mit einer spiegelnden Fläche ausgebildeter Körper (15) angeordnet ist, der von unten in die Längsbohrung (9) des Greifers (6) einfallendes Licht in eine horizontale Ebene (17) umlenkt, dass der Greifer (6) für das Licht der Lichtquelle (10) durchlässige Stellen aufweist, und dass am Bondkopf(5) mindestens ein optisches Element (19; 19.1, 19.2) angeordnet ist, das wenigstens einen Teil des umgelenkten, seitlich aus dem Greifer (6) austretenden Lichtes auf dem Photosensor (18) konzentriert.

2. Vorrichtung nach Anspruch 1, **dadurch gekennzeichnet, dass** das optische Element (19) ein Reflektor mit der Form einer Ellipse ist, wobei die spiegelnde Fläche des Körpers (15) im ersten Brennpunkt (20) und der Photosensor (18) im zweiten Brennpunkt (21) der Ellipse angeordnet sind.

3. Vorrichtung nach Anspruch 1, **dadurch gekennzeichnet, dass** das optische Element (19) eine Linse ist und dass ein zweites optisches Element in Gestalt eines Reflektors vorhanden ist.

4. Vorrichtung nach einem der Ansprüche 1 bis 3, **dadurch gekennzeichnet, dass** das bzw. die optischen Elemente (19) und der Photosensor (18) in einem lichtundurchlässigen Gehäuse untergebracht sind.
